# EUROPEAN PATENT SPECIFICATION

(11) **EP 3 764 408 B1**
(45) Date of publication and mention of the grant of the patent: **17.09.2025**
(21) Application number: 19764312.5
(22) Date of filing: 05.03.2019
(51) Int. Cl.: H10H 29/01, H10H 29/02, H10H 20/01, G01R 31/26, H10H 29/24, H10H 29/30, H01L 21/66

(54) **METHOD FOR MANUFACTURING A MICRO-LED CARRIER SUBSTRATE**
VERFAHREN ZUR HERSTELLUNG EINES MIKRO-LED-TRÄGERSUBSTRATS
PROCÉDÉ DE FABRICATION D'UN SUBSTRAT DE SUPPORT DE MICRO-DELS

(30) Priority: 06.03.2018 KR 20180026160
(43) Date of publication of application: 13.01.2021
(73) Proprietor: Samsung Electronics Co., Ltd., Gyeonggi-do 16677 (KR)
(72) Inventor: JANG, Kyungwoon, Suwon-si Gyeonggi-do 16677 (KR); LEE, Changjoon, Suwon-si Gyeonggi-do 16677 (KR); HWANG, Daesuck, Suwon-si Gyeonggi-do 16677 (KR)
(74) Representative: Arnold & Siedsma
(86) International application number: PCT/KR2019/002491
(87) International publication number: WO 2019/172594

(56) References cited:
- JP-A- 2014 072 330
- KR-A- 20100 055 911
- KR-A- 20120 044 736
- KR-A- 20170 019 415
- KR-A- 20170 073 590
- KR-B1- 101 800 367
- US-A1- 2012 028 375
- US-A1- 2014 299 911
- US-A1- 2015 076 549
- US-A1- 2015 380 619
- US-A1- 2017 373 122

## Description

### Technical Field

The present disclosure relates to a substrate for an electric element and a method for manufacturing the same, and more particularly to a substrate for a current flow inspection of an electric element and a method for manufacturing the same.

### Background Art

In recent years, electric elements such as micro LEDs tend to be replaced by pixels of displays. Because an existing long-distance display (e.g., an outdoor long-distance display) employs an LED package of a size of several millimeters, it is not suitable for short distances or homes. Accordingly, in order to realize a short-distance display, a problem of having to transfer an LED of several tens of µm to several hundred µm capable of coping with the current pixels to a substrate with precision and at a high yield rate should be solved in advance. The size of one pixel of a domestic display that is currently being developed is normally about 100 µm, and the size of an R/G/B sub-pixel is merely several tens of µm.

In recent years, although LEDs having sizes of several tens of µm corresponding to the size of the pixels applied to the above-described short-range display are manufactured in a deposition method through wafers, an inspection of the electrical qualities of the manufactured micro elements is very difficult due to the sizes.

A substrate known in the art and a method for manufacturing the same are for example disclosed in US 2015/0380619 A1, which discloses an anchor area physically secured to a surface of the substrate and at least one printable electronic component, possibly being an inorganic LED. The at least one printable electronic component includes an active layer having one or more active elements thereon, and is suspended over the surface of the substrate by electrically conductive breakable tethers. The electrically conductive breakable tethers include an insulating layer and a conductive layer thereon that physically secure and electrically connect the at least one printable electronic component to the anchor area, and are configured to be preferentially fractured responsive to pressure applied thereto. Testing of said printable electronic component is also disclosed by this prior art document.

A micro LED display panel known in the art is for example the one disclosed in US 2017/0373122 A1, which is provided by disposing a plurality of active areas on the substrate arranged in an array, and a plurality of micro LEDs uniformly arranged in each active area. According to the disclosure, this achieves a high-resolution of micro LED display panel. The panel is further provided while controlling the number of micro LEDs in each active area. According to the disclosure, this allows for effectively controlling the production cost, while eliminating the screen door effect, to enhance market competitiveness of micro LED display panel.

A method of manufacturing an individual mounting board known in the art is for example the one disclosed in JP 2014-72330 A, which comprises a diode mounting step of mounting a plurality of diodes D on an aggregate metal base circuit board; a conduction test step of performing conduction test of the diodes D; and an individualization step of individualizing the aggregate metal base circuit board mounting the plurality of diodes D into a plurality of individual mounting boards. The conduction test step is after the diode mounting step and before the individualization step, and in the conduction test step, conduction test of all diodes D is performed collectively while the plurality of diodes D are mounted on the aggregate metal base circuit board.

A method for inspecting a light-emitting device known in the art is for example the one disclosed in US 2012/0028375 A1, which includes performing a light emission test of (A) a light-emitting device including a lead frame having mounted and packaged thereon a plurality of light-emitting elements or (B) a light-emitting device obtained by resin encapsulating and packaging the light-emitting device (A), by applying a current to the plurality of light-emitting elements and judging each light-emitting element as passed or failed, in which arrangement of the plurality of light-emitting elements in the light-emitting device is set as in the following : In a lead frame having a lattice form including a plurality of rows and a plurality of columns with a plurality of intersection points formed thereby, a plurality of light-emitting elements are disposed between the adjacent intersection points in each row, the adjacent light-emitting elements in each row are connected to each other so that positive electrode terminals or negative electrode terminals thereof face each other, and a positive-side power supply channel or a negative-side power-supply channel in the lead frame works as a common channel between a certain column and a column adjacent thereto.

A method for producing optoelectronic semiconductor components known in the art is for example the one disclosed in US 2015/0076549 A1. In this method, a lead frame assemblage includes a plurality of lead frames. The lead frames each includes at least two lead frame parts and the lead frames in the lead frame assemblage are electrically connected to one another by connecting webs. The lead frame assemblage is fitted on an intermediate carrier. At least a portion of the connecting webs is removed and/or interrupted. Additional electrical connecting elements are fitted between adjacent lead frames and/or lead frame parts. A potting body mechanically connects the lead frame parts of the individual lead frames to one another. The resulting structure is singulated to form the semiconductor components.

A method for producing a packaged component known in the art is for example the one disclosed in US 2014/0299911 A1. In one embodiment thereof, a lead frame composite has first lead frame parts, second lead frame parts and test contacts, electrically connecting via first electrical connections the first lead frame parts to the other first lead frame parts. A potting body is formed on the lead frame composite thereby mechanically connecting the first lead frame parts to the second lead frame parts and encapsulating the first electrical connections. First semiconductor components are placed on the first lead frame parts after forming the potting body. The first semiconductor components are electrically connected to the second lead frame parts via second electrical connections. The first semiconductor components are electrically tested at the test contacts prior to singulating the lead frame composite and the potting body. The lead frame composite and the potting body are singulated thereby forming the packaged semiconductor components.

### Disclosure of Invention

### Technical Problem

In general, when fine chips such as micro LEDs are mounted in the form of flip chips, a method of directly transferring the chips from wafers to substrates due to the many disadvantages of the process may be used. In this case, although the excellent precision of the micro LEDs can be secured according to the pitch or size of the wafers formed through a semiconductor process, a method for sorting and mounting known good dies (KGDs) inspected in the wafers may be required. Although an inspection of the light emission efficiencies and wavelengths of the micro LED wafers may be performed through a photo luminescence (P/L) inspection, an inspection of the electrical qualities of the micro LED wafers in a conventional probing scheme is very difficult in reality because the determination of the electrical qualities performed by actually applying electrical signals is difficult due to the sizes and connection structures of the pads thereof.

The present invention provides a method for manufacturing a micro LED carrier substrate in accordance with the appended claim 1.

Various further embodiments of the present invention are the object of the appended dependent method claims.

Various embodiments of the present invention provide a method for manufacturing a carrier substrate that may improve the yield rate of a product by performing an inspection of electrical qualities during the manufacturing process of a plurality of micro LEDs, before a substrate is mounted, and enhance the efficiency of an operation process.

### Solution to Problem

In accordance with the present invention, there is provided a method for manufacturing a carrier substrate according to the appended claim 1.

In accordance with further aspects of the present invention, there is provided the method according to the appended dependent claims.

### Advantageous Effects of Invention

According to various embodiments of the present invention, an efficient operation can be performed because electrical qualities can be inspected during the manufacturing process. In particular, because the electrical qualities of micro LEDs can be determined before the micro LEDs are mounted on a display substrate, the yield rate of the product and the efficiency of the manufacturing time can be increased.

In the following, various embodiments will be described in association with corresponding drawings. Some embodiments of the present disclosure are embodiments of the present invention as defined by the claims, while others are embodiments of the present disclosure not forming part of the present invention as claimed, but being useful for understanding the invention and for illustrating its context.

### Brief Description of Drawings

FIG. 1 is a view illustrating a configuration of a display, to which micro LEDs are applied, according to various embodiments of the disclosure.
FIG. 2 is a flowchart illustrating a process of manufacturing micro LEDs according to various embodiments of the disclosure.
FIGS. 3A to 3I are diagrams illustrating a process sequence of the micro LEDs manufactured through the process of FIG. 2 according to various embodiments of the disclosure.
FIGS. 4A and 4B are views illustrating a state in which micro LEDs disposed in a carrier substrate are separated by a pickup device according to various embodiments of the disclosure.

### Best Mode for Carrying out the Invention

The embodiments of the present invention are those falling under the scope of the appended claims. It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software including one or more instructions that are stored in a storage medium that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Hereafter, a method for manufacturing a display, which includes a micro LED current flow inspection, according to various embodiments of the disclosure will be described with reference to the accompanying drawings.

Because a configuration of a display according to an exemplary embodiment of the disclosure is realized regardless of the sizes of LEDs, the sizes of the used LEDs are not limited. For example, a display for lighting may employ LEDs of several millimeters, a large-scale display such as indoor/outdoor signages may employ LEDs of several hundred micrometer LEDs, and a short-range display may employ LEDs of several tens of micrometers.

Further, although methods for inspecting current flows of micro LEDs and manufacturing micro LEDs are illustrated and described in the exemplary embodiments of the disclosure, the disclosure is not limited thereto. For example, the disclosure may be applied to various electric elements that may use the current flow inspection and the manufacturing method.

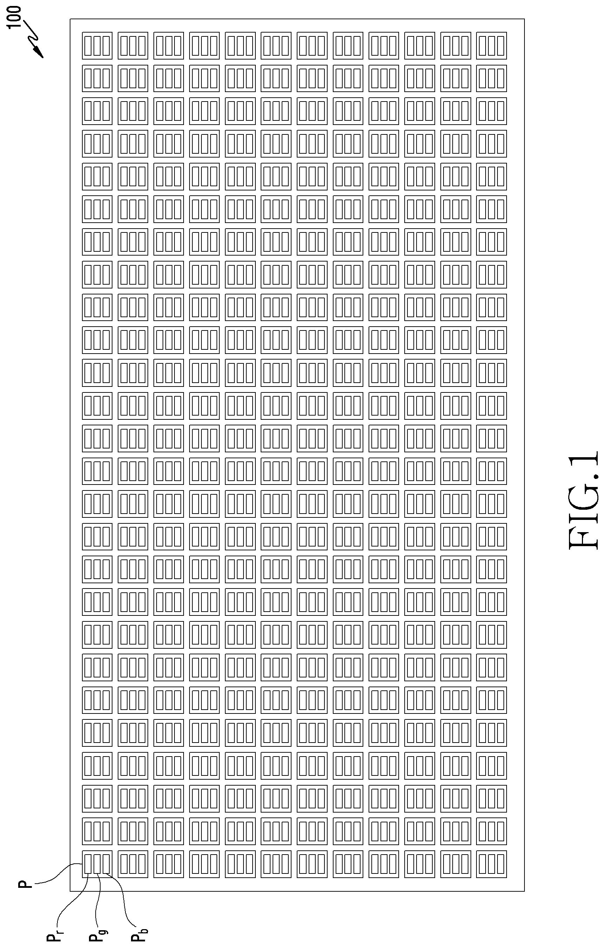

FIG. 1 is a view illustrating a configuration of a display, to which micro LEDs are applied, according to various embodiments of the disclosure.

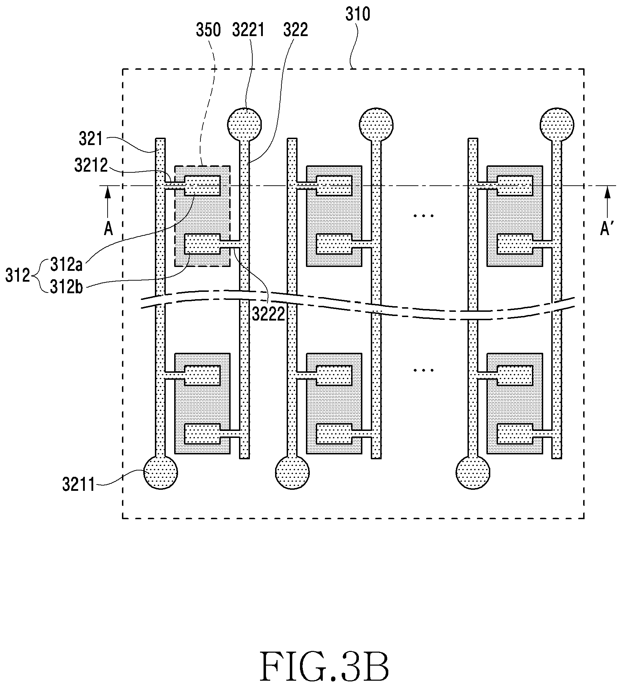

Referring to FIG. 1, a display 100 may include a plurality of pixels P disposed at a predetermined interval. According to an embodiment, the unit pixels P may include sub-pixels Pr, Pg, and Pb. According to an embodiment, the sub-pixels Pr, Pg, and Pb, for example, may be micro LEDs (e.g., the micro LEDs 350 of FIG. 3B) having an area of 10000 µm² or less.

According to various embodiments, before the micro LEDs are mounted on the substrate of the display 100, a current flow inspection for determining the electrical qualities of the micro LEDs may be performed in advance. According to an embodiment, because the micro LEDs, on which the current flow inspection is performed, are mounted on the substrate of the display 100, the yield rate of the display 100 can be increased.

Hereinafter, a process of manufacturing micro LEDs corresponding to the sub-pixels of the display will be described.

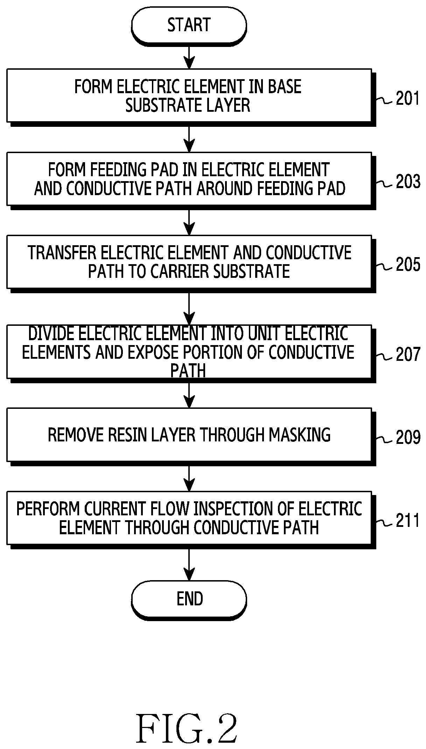

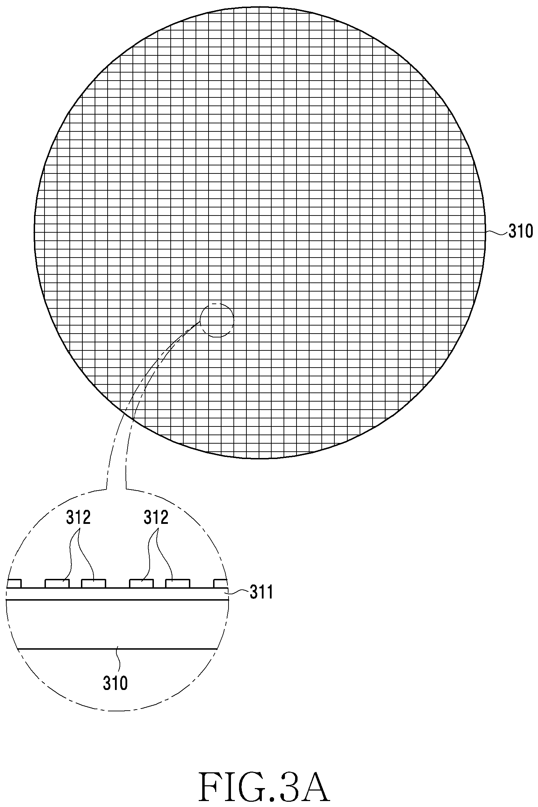

FIG. 2 is a flowchart illustrating a process of manufacturing micro LEDs according to various embodiments of the disclosure. FIGS. 3A to 3I are diagrams illustrating a process sequence of the micro LEDs manufactured through the process of FIG. 2 according to various embodiments of the disclosure.

Referring to FIG. 2, in operation 201, as illustrated in FIG. 3A, micro LEDs (e.g., electric elements) may be formed in a base substrate layer 310 (e.g., a sapphire wafer). According to an embodiment, the micro LED may include a light emitting layer 311 deposited on the base substrate layer 310 before being divided into unit electric elements. According to an embodiment, the light emitting layer 311 may be formed to grow in a single crystal state of a composite semiconductor in a high-temperature/high-pressure state in a sapphire or SiX base substrate layer 310, and the color of the light emitting layer 311 may vary according to the composition thereof. For example, a red color may be realized by a composite semiconductor of GaAs, a green color may be realized by a composite semiconductor of InGaP, and a blue color may be realized by a composite semiconductor of GaN, and the wavelength of the light emitting layer 311 may be determined according to the natural energy bandgap values of the compositions and thus the color of the light emitting layer 311 may vary.

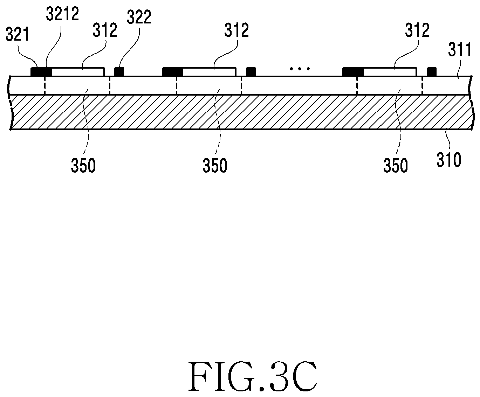

In operation 203, a feeding pad 312 and one or more conductive paths 321 and 322 may be formed in the feeding pad 312 and around the feeding pad 312 on the light emitting layer 311. FIG. 3B is a plan view of a base substrate layer 310, in which the feeding pad 312 and the conductive paths 321 and 322 are formed in the light emitting layer, and FIG. 3C is a cross-sectional view of the base substrate layer 310 viewed from line A-A' of FIG. 3B.

According to various embodiments, as illustrated in FIGS. 3B and 3C, the micro LEDs 350 may be arranged on the base substrate layer 310 at a predetermined interval. According to an embodiment, the micro LEDs 350 may be disposed on the base substrate layer 310 along rows and/or columns at a predetermined interval. According to an embodiment, each of the micro LEDs 350 may include one or more feeding pads 312 formed such that the micro LED 350 is electrically connected to a conductive pad of a display substrate in the base substrate layer 310 before the micro LED 350 is divided into unit micro LEDs. According to an embodiment, the feeding pads 312 may include a first feeding pad 312a and a second feeding pad 312b that is spaced apart from the first feeding pad 312a at a predetermined interval.

According to various embodiments, the one or more conductive paths 321 and 322 may include a first conductive path 321 disposed on one side of the plurality of micro LEDs arranged in rows and/or columns, and a second conductive path 322 disposed on an opposite side thereof. According to an embodiment, the first conductive path 321 and the second conductive path 322 may be disposed to extend along the rows and/or rows of the plurality of micro LEDs 350 in the base substrate layer 310. According to an embodiment, the first conductive path 321 and the second conductive path 322 may be formed together when the feeding pads 312 are formed. According to an embodiment, the first conductive path 321 and the second conductive path 322 may be electrically connected to the feeding pads 312 of the micro LEDs 350 arranged in rows and/or columns at the same time. For example, the first feeding pad 312a of each of the plurality of micro LEDs 350 may be electrically connected to the first conductive path 321 through the first sub-electrical path 3212. The second feeding pad 312b of each of the plurality of micro LEDs 350 according to an embodiment may be electrically connected to the second conductive path 322 through the second sub-electrical path 3222. According to an embodiment, a first current flow inspection area 3211 may be disposed at one end of the first conductive path 321. According to an embodiment, a second current flow inspection area 3221 may be disposed at one end of the second conductive path 322. The first current flow inspection area 3211 and the second current flow inspection area 3221 may contribute as probe contact areas for a current flow inspection for determining the electrical quality.

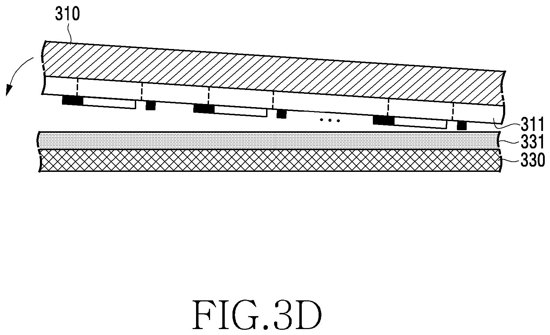

In operation 205, the micro LEDs 350 (e.g., the electric elements) and the one or more conductive paths 321 and 322 may be transferred to a carrier substrate 330. According to an embodiment, as illustrated in FIG. 3D, the light emitting layers 311, the feeding pads 312, and the conductive paths 321 and 322 may be transferred (e.g., attached) to the carrier substrate 330 (e.g., a carrier film) in which a resin layer 331 (e.g., a bonding layer) is disposed. According to an embodiment, a method for transferring the micro LEDs 350 and the conductive paths 321 and 322 to the carrier substrate 330 may be at least one of a method of using an uncured resin (liquid polyimide (PI)), polydimethylsiloxane (PDMS), polyethylene terephthalate (PET), epoxy, or the like, or methods of using a difference of the adhering forces of film type tapes such as an ultraviolet (UV) tape, a non-UV tape, or a thermally expandable tape.

In operation 207, the base substrate layer 310 may be removed from the carrier substrate 330, the plurality of micro LEDs 350 (e.g., the electric elements) are divided into unit micro LEDs 350 through an etching process, and the one or more conductive paths 321 and 322 may be exposed from the carrier substrate 330.

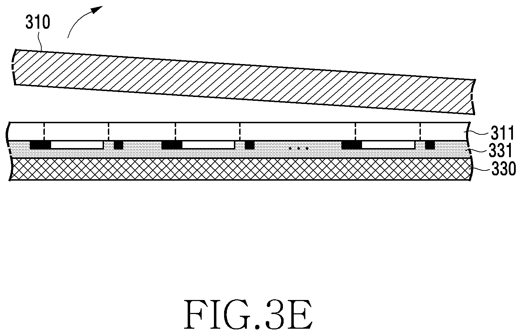

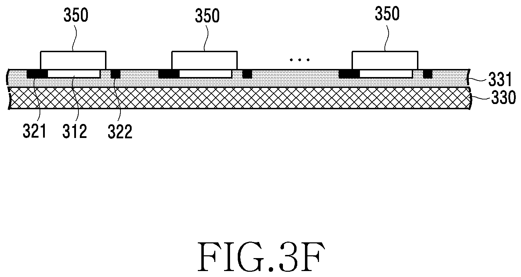

According to various embodiments, as illustrated in FIGS. 3E and 3F, the base substrate layer 310 may be separated from the light emitting layers 311 of the carrier substrate 330. According to an embodiment, the base substrate layer 310 may be separated from the carrier substrate 330 through a laser lift-off (LLO) process. An eximer or a DPSS may be used as the laser. According to an embodiment, a singulation process may be performed on the light emitting layers 311 to form individual micro LEDs 350. According to an embodiment, the light emitting layers 311 may be divided into unit micro LEDs 350 through an etching process. According to an embodiment, each of the unit micro LEDs 350 may include a feeding pad 312, and the feeding pad 312 may be electrically connected in common to the one or more conductive paths 321 and 322. The one or more conductive paths 321 and 322 may be disposed while being exposed from an upper portion of the resin layer 331 through an etching process.

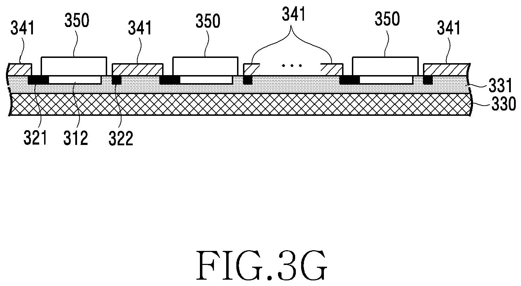

In operation 209, the resin layer 331 may be partially removed from the carrier substrate 330 divided into the unit micro LEDs 350. According to an embodiment, as illustrated in FIG. 3G, the mask 341 may be disposed between at least some of the first conductive paths 321 and the adjacent second conductive paths 322. According to an embodiment, the resin layer 331 on the carrier substrate 330 may be at least partially removed through a masking process.

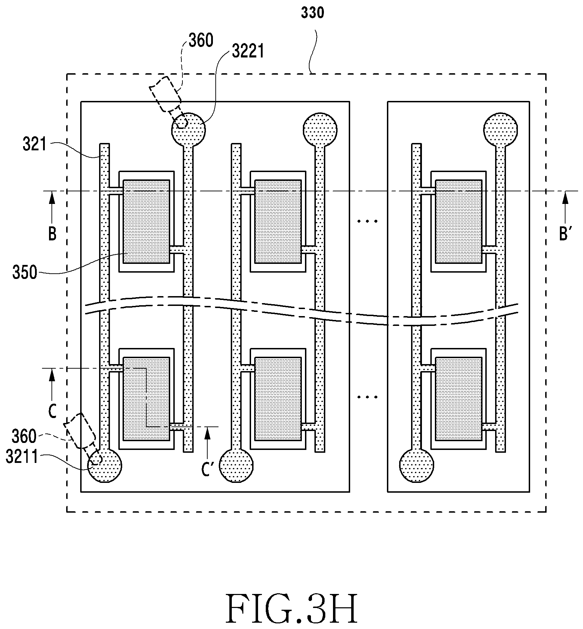

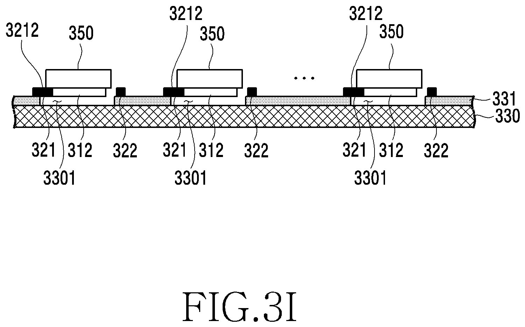

In operation 211, the current flow inspection for determining the qualities of the micro LEDs 350 may be performed through the conductive paths 321 and 322. FIG. 3H is a plan view of the carrier substrate 330, on which a masking operation has been performed, and FIG. 3I is a cross-sectional view of the carrier substrate 330 viewed from line B-B' of FIG. 3H.

According to an embodiment, if the resin layer 331 is at least partially removed through a masking process, the unit micro LEDs 350 may maintain a floated state while a specific space 3301 from the carrier substrate 330 on the lower side thereof is provided. According to an embodiment, the micro LEDs 350 may maintain a floated state in an anchor and tether structure on the space 3301, from which the resin layer has been removed, through the sub-electrical paths 3212 and 3222 branched from the conductive paths 321 and 322 and connected to the feeding pads 312 of the micro LEDs 350. According to an embodiment, a current flow inspection for determining the electrical qualities of the micro LEDs 350 may be performed by performing an electrical probing process by using the one or more conductive paths 321 and 322. For example, as a probe 360 for current flows contacts a first current flow inspection area 3211 (e.g., a (+) current application area) of the first conductive path 321 and a second current flow inspection area 3221 (e.g., a (-) current application area) of the second conductive path 322, current may flow through the unit micro LEDs 350. According to an embodiment, although a normal micro LED may emit light through a current flow inspection for determining the electrical quality of the micro LED, an abnormal micro LED may not emit light. According to an embodiment, the micro LED that is determined to be defective may be removed or may be excluded from a pickup process through information on a location of the carrier substrate 330.

According to various embodiments, the micro LEDs 350 floated in an anchor and tether structure on the carrier substrate 330 may be mounted on the display substrate through a pickup device.

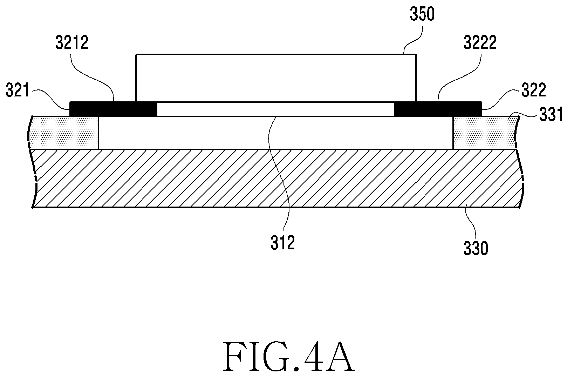

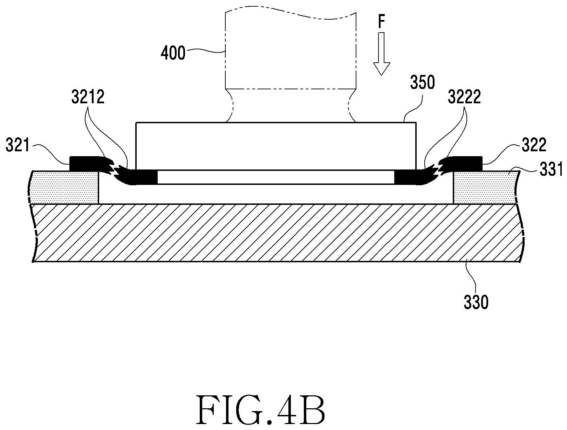

FIGS. 4A and 4B are views illustrating a state in which micro LEDs 350 disposed in a carrier substrate 330 are separated by a pickup device 400 according to various embodiments of the disclosure.

FIGS. 4A and 4B are cross-sectional view viewed from line C-C' of FIG. 3H.

Referring to FIGS. 4A and 4B, the micro LEDs 350 in which the resin layer 331 is partially removed from the carrier substrate 330 and which are floated to have an anchor and tether structure through the sub-electrical paths 3212 and 3211 branched from the electrical paths 321 and 322 may be picked up by the pickup device 400. In this case, the micro LEDs 350 may be picked up by a pickup force F of the pickup device 400 while the sub-electrical paths 3212 and 3222 are broken. For example, the sub-electrical paths 3212 and 3222 may be interrupted from the conductive paths 321 and 322 after the current flow inspection of the electrical qualities of the micro LEDs 350 are performed. Accordingly, the sub-electrical paths 3212 and 3222 that electrically connect the conductive paths 321 and 322 and the feeding pads 312 of the micro LEDs 350 may be used for an inspection of the electrical qualities, and may contribute to floating disposition of the micro LEDs 350 by the anchor and tether structure due to removal of the resin layer 331 between the carrier substrate 330 and the micro LEDs 350.

According to various embodiments, a substrate may include a base substrate layer, a plurality of unit electric elements arranged on the base substrate layer at a predetermined interval, and one or more conductive paths electrically connected to the plurality of unit electric elements around the plurality of unit electric elements, respectively, and each of which has a current flow inspection area at an end thereof, wherein the electrical qualities of the plurality of unit electric elements are determined by using the current flow inspection areas of the conductive paths.

According to various embodiments, each of the plurality of unit electric elements may have a micro LED having an area of a range of 10000 µm² or less.

According to various embodiments, the substrate may include a resin layer disposed between the base substrate layer and the plurality of unit electric elements, and one or more feeding pads disposed in the plurality of unit electric elements, respectively, and the feeding pads may be electrically connected to the one or more conductive paths.

According to various embodiments, the substrate may include one or more sub-electric paths branched from the conductive paths and extending to the feeding pads corresponding to the plurality of unit electric elements.

According to various embodiments, the resin layer between the plurality of unit electric elements and the base substrate layer may be removed, and the plurality of unit electric elements may be floated in an anchor and tether structure through the one or more sub-electric path.

According to various embodiments, the base substrate layer may include a carrier substrate, to which a micro LED is transferred.

According to various embodiments, the plurality of unit electric elements may be disposed in rows and/or columns at a predetermined interval, and the one or more conductive paths are disposed to extend along the rows and/or columns around the unit electric elements.

According to various embodiments, a carrier substrate may include a substrate, a plurality of micro LEDs arranged on the substrate at a predetermined interval, and one or more conductive paths electrically connected to the plurality of micro LEDs around the plurality of micro LEDs, respectively, and having current flow inspection areas at ends thereof, and the electrical qualities of the plurality of micro LEDs may be determined by using current flow inspection areas of the conductive paths.

According to various embodiments, the areas of the plurality of micro LEDs may be 10000 µm² or less.

According to various embodiments, the carrier substrate may include resin layers disposed between the substrate and the plurality of micro LEDs, and one or more feeding pads disposed in the plurality of micro LEDs, respectively, and the feeding pads may be electrically connected to the one or more conductive paths.

According to various embodiments, the carrier substrate may include one or more sub-electrical paths branched from the conductive paths and extending to the feeding pads corresponding to the plurality of divided micro LEDs.

According to various embodiments, the resin layer may be removed between the plurality of micro LEDs and the substrate, and the plurality of micro LEDs may be floated in an anchor and tether structure through the one or more sub-electric path.

According to various embodiments, the plurality of electric elements are disposed on the substrate in rows and/or columns at a predetermined interval, and the one or more conductive paths may be disposed to extend along the rows and/or columns around the micro LEDs.

According to various embodiments, a method for manufacturing a carrier substrate may include forming a plurality of light emitting layers in a base substrate layer, forming one or more conductive paths such that the conductive paths are electrically connected in common to the plurality of light emitting layers around the light emitting layers, transferring the conductive paths and the light emitting layers to the carrier substrate, dividing the light emitting layers transferred to the carrier substrate into a plurality of unit micro LEDs, and performing a current flow inspection for determining the qualities of the divided micro LEDs through the one or more conductive paths.

According to various embodiments, the method may include transferring the conductive paths and the light emitting layers to the carrier substrate by using a resin layer.

According to various embodiments, the method may include removing at least a portion of the resin layer, and the divided micro LEDs may be floated from the carrier substrate by the removed resin layer and the one or more conductive paths.

According to various embodiments, the removing of the resin layer may include removing a portion of the resin layer, which overlaps at least a portion of the conductive path, through a masking process.

According to various embodiments, the method may include one or more sub-electric paths branched from the conductive paths and extending to the feeding pads corresponding to the plurality of divided micro LEDs, and the plurality of micro LEDs are floated in an anchor and tether structure through the one or more sub-electric path.

According to various embodiments, the plurality of divided micro LEDs may be disposed along rows and/or columns on the carrier substrate at a predetermined interval, and the one or more conductive paths may be disposed to extend along the rows and/or columns around the micro LEDs.

According to various embodiments, each of the micro LEDs may have one or more feeding pad, and the one or more conductive paths may be formed together when the feeding pads are formed.

The embodiments described and shown in the specification and the drawings have presented specific examples in order to easily explain the technical contents of embodiments and help understanding of embodiments, and are not intended to limit the scope of embodiments. Therefore, the scope of various embodiments should be construed to include, in addition to the embodiments disclosed herein, all changes and modifications that are derived on the basis of the various embodiments The scope of the present invention is defined by the following claims 1-6.

## Claims

1. A method for manufacturing a carrier substrate (330), the method comprising:
forming (201) a plurality of light emitting layers (311) in a base substrate layer (310);
forming (203) a plurality of feeding pads (312) and a plurality of conductive paths (321, 322) such that the feeding pads (312) and the conductive paths (321, 322) are electrically connected in common to the plurality of light emitting layers (311) and such that the conductive paths (321, 322) are around the feeding pads (312);
transferring (205) the plurality of conductive paths (321, 322), the plurality of feeding pads (312), and the light emitting layers (311) to the carrier substrate (330);
dividing (207) the light emitting layers (311) transferred to the carrier substrate (330) into a plurality of unit micro LEDs (350); and
performing (211) a current flow inspection for determining the qualities of the divided micro LEDs (350) through the plurality of conductive paths (321, 322).

2. The method of claim 1, comprising:
transferring (205) the conductive paths (321, 322), the plurality of feeding pads (312), and the light emitting layers (311) to the carrier substrate (330) by using a resin layer (331).

3. The method of claim 2, further comprising:
removing at least a portion of the resin layer (331),
wherein the divided micro LEDs (350) are floated from the carrier substrate (330) by the removed resin layer (331) and the plurality of conductive paths (321, 322).

4. The method of claim 3, wherein the removing of the resin layer (331) comprises:
removing a portion of the resin layer (331), which overlaps at least a portion of the conductive path (321, 322), through a masking process.

5. The method of claim 4, further comprising:
forming one or more sub-electric paths (3212, 3222) branched from the conductive paths (321, 322) and extending to the feeding pads (312) corresponding to the plurality of divided micro LEDs (350),
wherein the plurality of micro LEDs (350) are floated in an anchor and tether structure through the one or more sub-electric path (3212, 3222).

6. The method of claim 1, wherein the plurality of divided micro LEDs (350) are disposed along rows and/or columns on the carrier substrate (330) at a predetermined interval, and
wherein the plurality of conductive paths (321, 322) are disposed to extend along the rows and/or columns around the micro LEDs (350).

## Patentansprüche

1. Verfahren zum Herstellen eines Trägersubstrats (330), wobei das Verfahren Folgendes umfasst:
Bilden (201) einer Vielzahl von lichtemittierenden Schichten (311) in einer Basissubstratschicht (310);
Bilden (203) einer Vielzahl von Zuleitungspads (312) und einer Vielzahl von Leiterbahnen (321, 322), so dass die Zuleitungspads (312) und die Leiterbahnen (321, 322) gemeinsam elektrisch mit der Vielzahl von lichtemittierenden Schichten (311) verbunden sind, und so dass die Leiterbahnen (321, 322) um die Zuleitungspads (312) herum verlaufen;
Übertragen (205) der Vielzahl von Leiterbahnen (321, 322), der Vielzahl von Zuleitungspads (312) und der lichtemittierenden Schichten (311) auf das Trägersubstrat (330);
Unterteilen (207) der auf das Trägersubstrat (330) übertragenen lichtemittierenden Schichten (311) in eine Vielzahl von einheitlichen Mikro-LEDs (350); und
Durchführen (211) einer Stromflussprüfung zum Bestimmen der Qualitäten der unterteilten Mikro-LEDs (350) durch die Vielzahl von Leiterbahnen (321, 322).

2. Verfahren nach Anspruch 1, umfassend:
Übertragen (205) der Leiterbahnen (321, 322), der Vielzahl von Zuleitungspads (312) und der lichtemittierenden Schichten (311) auf das Trägersubstrat (330) unter Verwendung einer Harzschicht (331).

3. Verfahren nach Anspruch 2, ferner umfassend:
Entfernen zumindest eines Teils der Harzschicht (331),
wobei die unterteilten Mikro-LEDs (350) durch die entfernte Harzschicht (331) und die Vielzahl von Leiterbahnen (321, 322) im Verhältnis zum Trägersubstrat (330) schwebend angeordnet sind.

4. Verfahren nach Anspruch 3, wobei das Entfernen der Harzschicht (331) Folgendes umfasst:
Entfernen eines Teils der Harzschicht (331), der zumindest einen Teil der Leiterbahn (321, 322) überlappt, durch einen Maskierungsprozess.

5. Verfahren nach Anspruch 4, ferner umfassend:
Bilden eines oder mehrerer elektrischer Nebenbahnen (3212, 3222), die von den Leiterbahnen (321, 322) abzweigen und sich zu den Zuleitungspads (312) erstrecken, die der Vielzahl von unterteilten Mikro-LEDs (350) entsprechen,
wobei die Vielzahl von Mikro-LEDs (350) in einer Anker- und Halteseilstruktur durch die eine oder die mehreren elektrischen Nebenbahnen (3212, 3222) schwebend angeordnet sind.

6. Verfahren nach Anspruch 1, wobei die Vielzahl von unterteilten Mikro-LEDs (350) entlang Reihen und/oder Spalten auf dem Trägersubstrat (330) in einem vorbestimmten Abstand angeordnet sind, und
wobei die Vielzahl von Leiterbahnen (321, 322) so angeordnet sind, dass sie sich entlang der Reihen und/oder Spalten um die Mikro-LEDs (350) erstrecken.

## Revendications

1. Procédé de fabrication d'un substrat porteur (330), le procédé comprenant :
la formation (201) d'une pluralité de couches électroluminescentes (311) dans une couche de substrat de base (310),
la formation (203) d'une pluralité de plots d'alimentation (312) et d'une pluralité de pistes conductrices (321, 322) de telle façon que les plots d'alimentation (312) et les pistes conductrices (321, 322) sont reliés électriquement en commun à la pluralité de couches électroluminescentes (311) et de telle façon que les pistes conductrices (321, 322) se trouvent autour des plots d'alimentation (312),
le transfert (205) de la pluralité de pistes conductrices (321, 322), de la pluralité de plots d'alimentation (312) et des couches électroluminescentes (311) sur le substrat porteur (330),
la division (207) des couches électroluminescentes (311) transférées sur le substrat porteur (330) en une pluralité de micro-LED (350) unitaires, et
la réalisation (211) d'une inspection du flux de courant pour déterminer les qualités des micro-LED (350) divisées, à travers la pluralité de pistes conductrices (321, 322).

2. Procédé selon la revendication 1, comprenant :
le transfert (205) des pistes conductrices (321, 322), de la pluralité de plots d'alimentation (312) et des couches électroluminescentes (311) sur le substrat porteur (330) au moyen d'une couche de résine (331).

3. Procédé selon la revendication 2, comprenant en outre :
le retrait d'au moins une partie de la couche de résine (331) ;
lesdites micro-LED (350) divisées étant à l'état flottant par rapport au substrat porteur (330) sous l'effet de la couche de résine (331) retirée et de la pluralité de pistes conductrices (321, 322).

4. Procédé selon la revendication 3, dans lequel le retrait de la couche de résine (331) comprend :
le retrait, par un processus de masquage, d'une partie de la couche de résine (331) qui chevauche au moins une partie du chemin conducteur (321, 322).

5. Procédé selon la revendication 4, comprenant en outre :
la formation d'une ou plusieurs sous-pistes électriques (3212, 3222) se ramifiant à partir des pistes conductrices (321, 322) et s'étendant jusqu'aux plots d'alimentation (312) correspondant à la pluralité de micro-LED (350) divisées ;
ladite pluralité de micro-LED (350) étant à l'état flottant dans une structure d'ancrage et d'attache procurée par la pluralité de sous-pistes électriques (3212, 3222).

6. Procédé selon la revendication 1, dans lequel la pluralité de micro-LED (350) divisées sont disposées en rangées et/ou colonnes sur le substrat porteur (330) selon un intervalle prédéterminé, et dans lequel la pluralité de pistes conductrices (321, 322) sont disposées en s'étendant le long des rangées et/ou colonnes autour des micro-LED (350).
